# FASCICULE DE BREVET EUROPEEN

(11) **EP 3 034 461 B1**
(45) Date de publication et mention de la délivrance du brevet: **01.07.2020**
(21) Numéro de dépôt: 14199218.0
(22) Date de dépôt: 19.12.2014
(51) Int. Cl.: B81C 99/00, G04B 15/14, B32B 15/01

(54) **Fabrication d'un composant horloger multi-niveaux**
Herstellung einer mehrstufigen Uhrenkomponente
Production of a multi-level clock component

(43) Date de publication de la demande: 22.06.2016
(73) Titulaire: ROLEX SA, 1211 Genève 26 (CH)
(72) Inventeur: Calame, Florian, CH-1066 Epalinges (CH)
(74) Mandataire: Moinas & Savoye SARL

(56) Documents cités:
- EP-A1- 2 405 300
- CH-A2- 704 086

## Description

La présente invention concerne un procédé de fabrication d'un composant métallique par une technique de photolithographie et dépôt galvanique. Ce type de procédé est utilisé notamment pour la fabrication de composants métalliques se présentant sous la forme de microstructures tridimensionnelles à plusieurs niveaux, pour former notamment des composants de mouvement horloger. L'invention porte aussi sur un composant métallique en tant que tel, obtenu par un tel procédé de fabrication.

DGC Mitteilungen No. 104, 2005, mentionne l'utilisation de la technologie LIGA (Lithographie Galvanik Abformung : méthode conçue par W. Ehrfeld du Karlsruhe Nuclear Research Center, Allemagne) pour la fabrication de pièces métalliques horlogères de haute précision, telles que par exemple des ancres ou des roues d'échappement. Ce procédé comprend la formation d'un moule en résine sensible aux rayons X, par irradiation avec un faisceau de rayons X de haute énergie généré par un synchrotron, ce qui représente un inconvénient majeur.

A.B. Frazier et al., Journal of Microelectromechanical systems, 2, 2, June 1993, décrit la fabrication de structures métalliques par électrodéposition de métal dans des moules en résine photosensible (photorésist) à base de polyimide, préparés à l'aide d'un procédé utilisant une technologie appelée LIGA-UV, analogue à la technologie LIGA mentionnée ci-dessus mais avec une illumination UV de la résine à la place de l'irradiation aux rayons X.

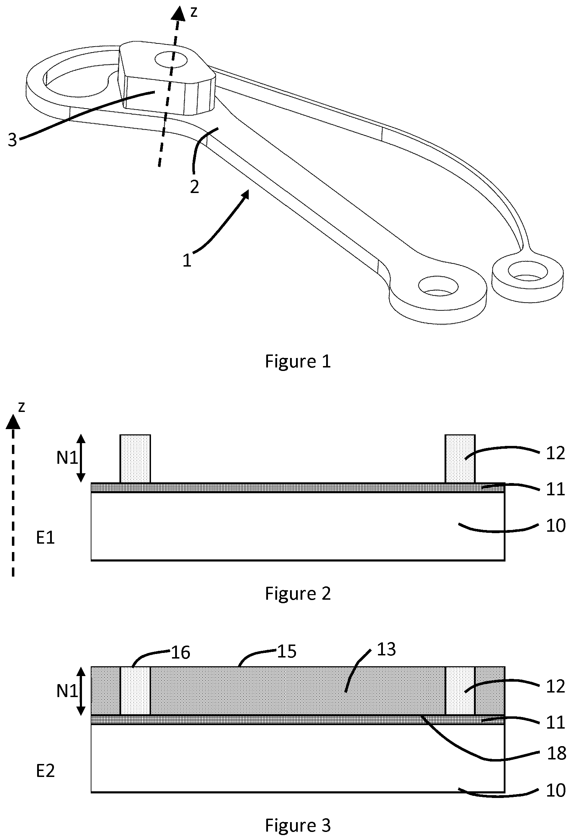

Les formes tridimensionnelles des composants horlogers sont souvent complexes, et comprennent des discontinuités formées par des portions superposées de sections très différentes. A titre d'exemple, la figure 1 représente un sautoir 1, comprenant une portion inférieure 2 de surface supérieure plane sur laquelle s'étend une seconde portion 3. Une telle forme tridimensionnelle est appelée « forme à plusieurs niveaux », car il est possible de distinguer deux portions 2, 3 superposées de sections très différentes dans une certaine direction z, formant une discontinuité au niveau de leur frontière, dans le plan de la surface supérieure de la portion inférieure 2. Chaque portion 2, 3 comprend une section par un plan perpendiculaire à la direction z sensiblement constante ou variant continument. Si les portions d'un composant présentant une forme à plusieurs niveaux sont réalisées par des couches distinctes de dépôt galvanique lors de la mise en œuvre d'un procédé LIGA, on constate une faiblesse du composant résultant au niveau de la frontière entre ces couches distinctes, qui peut conduire à une séparation accidentelle des couches. Il convient donc de définir un procédé de fabrication d'un composant horloger à plusieurs niveaux qui lui permet de supporter des contraintes mécaniques importantes, notamment de cisaillement et/ou de traction en direction verticale.

Le brevet EP2405300 décrit différents exemples de réalisation d'un procédé de fabrication d'une pièce métallique à au moins deux niveaux. Selon un exemple particulier de réalisation, le procédé comprend les étapes successives suivantes :
- déposer une première couche de résine photosensible sur un substrat recouvert d'une couche conductrice, cette première couche définissant un premier niveau ;
- obtenir un premier moule en réalisant une cavité dans la première couche de résine par photolithographie à l'aide d'un masque, suivie d'un développement de la résine ;
- déposer un métal ou un alliage dans le premier moule, par un dépôt galvanique amorcé par la couche conductrice, afin de former une couche métallique de premier niveau ;
- enlever complètement la résine restante de la première couche pour ne laisser sur le substrat que la couche métallique de premier niveau ;
- déposer une deuxième couche de résine sur le substrat, par exemple d'épaisseur plus importante que la couche métallique de premier niveau, puis, par photolithographie à l'aide d'un masque suivie d'un développement de la résine, former un espace creux délimité par la couche conductrice, les flancs de la couche métallique de premier niveau et des flancs de la deuxième couche de résine.

Cet espace creux constitue en définitive un deuxième moule dans lequel on peut déposer un métal ou alliage par un dépôt galvanique amorcé par la couche conductrice et former (après retrait de la résine et du substrat) un composant métallique ayant au moins deux niveaux imbriqués l'un dans l'autre.

En résumé, le document EP2405300 propose donc la fabrication d'un composant à plusieurs niveaux à l'aide de couches distinctes obtenues par un procédé LIGA, de sorte que ces couches distinctes soient imbriquées, ce qui leur permet de garantir une bonne liaison entre elles, réduisant ainsi le risque de leur séparation accidentelle. Toutefois, ce procédé est consommateur en temps de fabrication et complexifie les moules en résine à fabriquer pour la formation de chaque couche.

Le document EP0851295 décrit une autre approche reposant sur la réalisation d'une microstructure en résine photosensible avec des dépôts et insolations successives de résine, mais un développement de la résine insolée en une seule fois, pour obtenir un moule tridimensionnel complexe correspondant au composant à fabriquer. Ensuite, le composant est obtenu par un dépôt électrolytique au sein de ce moule. L'avantage de cette approche est d'obtenir un ensemble métallique monolithique, les différents niveaux étant réalisés lors d'une même étape, donc pouvant être assimilés à une seule couche. Il en résulte une meilleure résistance mécanique des portions des différents niveaux puisqu'il n'y a plus la faiblesse constatée par la frontière entre des couches distinctes. Son inconvénient est sa complexité, notamment pour former le moule en résine. Cette approche ne permet pas non plus d'obtenir toutes les formes souhaitées.

Ainsi, la présente invention a pour objet d'améliorer la situation et de proposer une solution de fabrication d'un composant métallique tridimensionnel qui lui permet une résistance mécanique satisfaisante, notamment lorsqu'il se présente selon une forme à au moins deux niveaux.

A cet effet, l'invention concerne un procédé de fabrication d'un composant horloger, notamment à plusieurs niveaux, comprenant une étape de fabrication d'au moins une couche métallique du composant horloger présentant une surface supérieure, caractérisé en ce qu'il comprend les étapes suivantes :
- Former au moins une cavité dans la surface supérieure de la couche métallique du composant horloger, la cavité comprenant la réalisation d'au moins un flanc non perpendiculaire à ladite surface supérieure de la couche métallique, de sorte que ladite cavité comprend une section plane plus importante à au moins une profondeur sous le niveau de la surface supérieure que la section de son ouverture au niveau de la surface supérieure ;
- Former une autre couche métallique au moins partiellement superposée à ladite surface supérieure comprenant une cavité, par un dépôt galvanique d'un métal ou d'un alliage, remplissant au moins ladite cavité.

L'invention porte aussi sur un composant horloger, notamment à plusieurs niveaux, comprenant deux niveaux adjacents formés par deux couches métalliques distinctes au moins partiellement superposés, la seconde couche métallique recouvrant au moins partiellement la surface supérieure de la première couche métallique, caractérisé en ce que la première couche métallique présente au moins une cavité et en ce que la seconde couche métallique occupe le volume de ladite cavité de la première couche métallique, de sorte que les deux couches métalliques sont imbriquées et/ou encastrées et fixées l'une à l'autre au niveau de leur interface. Elles sont solidaires et fixées (non mobiles) l'une à l'autre. Elles forment un ensemble monolithique.

La première couche métallique a au moins une cavité présentant un flanc non perpendiculaire à la surface supérieure de la première couche métallique aux abords de la cavité, notamment un flanc incliné de sorte que la section de la cavité augmente en s'éloignant de la surface supérieure de la première couche métallique ou notamment une section en forme de queue d'aronde dans un plan perpendiculaire à la surface supérieure dudit composant.

L'invention est définie par les revendications.

Ces objets, caractéristiques et avantages de la présente invention seront exposés en détail dans la description suivante de modes de réalisation particuliers faits à titre non-limitatif en relation avec les figures jointes parmi lesquelles :
La figure 1 représente une vue en perspective d'un sautoir pour mouvement d'horlogerie.
Les figures 2 à 8 illustrent les étapes successives du procédé de fabrication d'un composant métallique selon un mode de réalisation de l'invention.
Les figures 9 à 12 illustrent la mise en œuvre du procédé de fabrication selon le mode de réalisation de l'invention pour fabriquer un sautoir.
Les figures 13 à 18 illustrent les étapes successives du procédé de fabrication d'un composant métallique selon une variante du mode de réalisation de l'invention.

Nous allons décrire un procédé de fabrication d'un composant métallique, particulièrement adapté à la fabrication de microstructures à plusieurs niveaux, notamment pour fabriquer des composants horlogers. Pour une raison de simplification, nous utiliserons les termes « métal » et « métallique » par la suite pour désigner un matériau métallique ou un alliage métallique.

La première étape E1 du procédé de fabrication consiste à fabriquer un premier moule de premier niveau N1 sur un substrat 10. Ce substrat 10 peut être constitué par une plaquette métallique, notamment en alliage comme un acier inoxydable, ou une plaquette de silicium, de verre ou de céramique. Ce substrat est de préférence massif, mais peut également comporter des structures réalisées par microfabrication. Il est préparé selon les règles connues de l'homme de l'art, notamment pour son dégraissage, nettoyage, éventuellement passivation et/ou activation. Ce substrat est avantageusement plan. En variante, il peut comporter des motifs, notamment des motifs usinés, et/ou des cavités, et/ou d'autres structures, selon les enseignements de l'art antérieur. Notamment, il peut comporter des logements pour placer un ou plusieurs inserts destinés à être emprisonnés ou enserrés par les futures couches métalliques déposées pour appartenir finalement au composant métallique, de manière non mobile et non amovible. Dans l'exemple de réalisation illustré, le substrat 10 est dans un matériau conducteur, par exemple en acier inoxydable. En variante, on pourrait aussi utiliser un substrat en un matériau non-conducteur, comme par exemple le silicium.

Optionnellement, une couche conductrice 11 est déposée sur le substrat 10, par exemple par évaporation. Cette couche conductrice 11 est notamment destinée à jouer le rôle de cathode pour l'amorçage d'un dépôt galvanique, ou électrodéposition, ultérieur. De façon connue, cette couche conductrice 11 d'amorçage peut comprendre une sous-couche de chrome, nickel ou de titane recouverte d'une couche d'or ou de cuivre (elle présente ainsi une structure multicouches).

La couche conductrice 11 est recouverte d'une couche initiale de résine photosensible sur une hauteur souhaitée. Cette hauteur est préférentiellement supérieure à 0 et inférieure ou égale à 1.5mm. La résine est une résine photosensible, adaptée à la photolithographie. La résine peut être négative ou positive. Dans le premier cas, elle est conçue pour devenir insoluble ou difficilement soluble à un révélateur sous l'action d'un rayonnement, alors que, dans le second cas, elle est conçue pour devenir soluble à un révélateur sous l'action d'un rayonnement, alors que la partie non exposée au rayonnement reste insoluble ou difficilement soluble. Dans l'exemple particulier de la description, la résine utilisée est de type « SU-8 », qui est une résine photosensible négative qui polymérise sous l'action d'un rayonnement UV, par exemple la résine SU-8-100 de la maison Microchem. Cette couche initiale de résine définit un premier niveau N1.

Une étape de photolithographie de la couche initiale de résine est réalisée, qui consiste à exposer à une radiation lumineuse ou insoler la couche initiale de résine à travers un masque comprenant des ouvertures et des zones opaques. Ce masque définit le motif à reproduire pour la réalisation du premier niveau du composant à fabriquer. Les radiations lumineuses utilisées pour irradier ou insoler la résine sont ici des rayonnements UV émis par une source UV. On pourrait toutefois envisager d'utiliser des rayons X, un faisceau d'électrons (on parle alors de lithographie par faisceau d'électrons) ou tout autre type de radiations selon la résine utilisée. Les rayonnements sont perpendiculaires au plan dans lequel s'étend le masque de manière à n'irradier que les zones de la résine situées au droit des ouvertures ménagées dans le masque. Dans l'exemple de réalisation particulier décrit ici, les zones de résine insolées deviennent insensibles ou insolubles à la plupart des liquides de développement.

L'étape précédente d'exposition à des radiations lumineuses (ou à un faisceau d'électrons) est suivie optionnellement d'une étape de traitement thermique de réticulation, puis d'une étape de développement. Le développement consiste à éliminer les zones de résine non exposées selon un procédé adapté à la résine utilisée, par exemple par dissolution avec un produit chimique ou par un procédé plasma. Après dissolution, la couche conductrice 11 apparaît aux endroits où la résine a été éliminée. Dans le cas d'une résine photosensible positive, les zones insolées seraient éliminées par exemple par voie chimique et les zones non insolées seraient conservées sur le substrat.

Les parties restantes de résine de la couche initiale forment un premier moule 12 en résine de premier niveau N1. Le fond du moule est délimité par la couche conductrice 11. A l'issue de l'étape de développement, on obtient donc le moule et la structure illustrée par la figure 2, dans laquelle un substrat 10 est recouvert d'une couche conductrice 11, sur laquelle un moule 12 en résine a été formé sur un premier niveau N1. Cette construction est réalisée dans une seule direction sensiblement perpendiculaire au substrat 10, que nous appellerons par convention direction verticale z, orientée vers le haut sur les figures de sorte que le moule de premier niveau N1 est considéré formé au-dessus du substrat 10, par convention. Ce substrat 10 plan définit de même par convention un plan horizontal.

Ces étapes de fabrication d'un moule en résine dans un procédé de type LIGA sont connues et ne sont pas illustrées plus en détail.

L'étape suivante E2 du procédé consiste à déposer une première couche métallique 13 dans les cavités du premier moule 12 en résine, par électrodéposition, ou dépôt galvanique. La couche conductrice 11 selon la réalisation illustrée ou en variante le substrat 10 si ce dernier est conducteur, joue le rôle de cathode pour amorcer le dépôt. Cette étape utilise par exemple le procédé LIGA et un métal tel que, par exemple, le nickel (Ni) ou le nickel-phosphore (NiP). La couche métallique 13 obtenue, représentée sur la figure 3, peut avoir la même hauteur que celle de la couche initiale de résine, correspondant à la hauteur du moule 12 de résine. Elle peut aussi avoir une hauteur inférieure à la hauteur du moule 12 de résine, ou une hauteur supérieure à la hauteur du moule 12 de résine. De façon optionnelle, cette étape E2 peut comprendre une mise d'épaisseur, par polissage mécanique simultané de la couche métallique et de la résine restante, pour obtenir une surface supérieure parfaitement plane, horizontale. La surface supérieure 15 de la couche métallique est alors parfaitement alignée avec la surface supérieure 16 du moule en résine 12, ces deux surfaces 16, 15 définissant donc le plan supérieur du premier niveau N1 de la structure intermédiaire obtenue après cette formation d'une première couche métallique 13. Ce plan est sensiblement horizontal sur ce mode de réalisation.

En variante de réalisation non représentée, la couche métallique 13 pourrait ne pas occuper toute la hauteur du premier moule 12, sa surface supérieure 15 restant sous la surface supérieure 16 du moule 12.

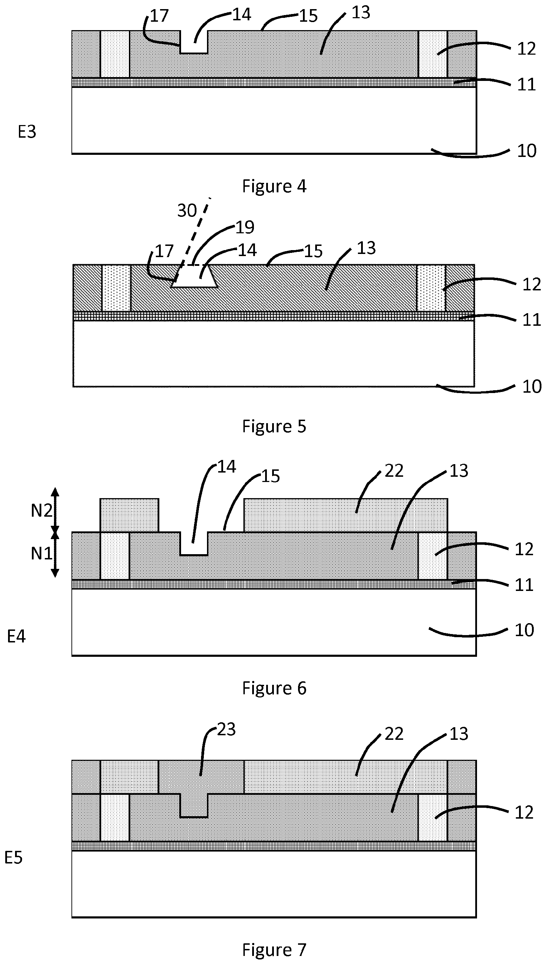

Le procédé comprend ensuite une étape E3 d'usinage de la première couche métallique 13, pour former une cavité 14, illustrée sur la figure 4. Comme cela sera détaillé par la suite, cette cavité a pour fonction de recevoir une partie de la seconde couche métallique qui va être superposée, afin de permettre d'imbriquer les deux couches métalliques.

Cette étape E3 de formation de la cavité 14 comprend une étape d'usinage mécanique, comme un fraisage et/ou un perçage, ou tout autre usinage mécanique. En variante, elle peut être réalisée par ablation laser, par exemple à partir d'un laser à impulsions femtoseconde. En variante, un usinage chimique, ou un usinage par ultrasons, ou un usinage par électroérosion, ou un usinage localisé par décharge dans un milieu diélectrique peut être utilisé.

Cette cavité 14 est formée par une action à partir de la surface supérieure 15 de la couche métallique 13. Dans cet exemple de réalisation, et de façon préférentielle, la cavité 14 finale se présente sous la forme d'un trou borgne. Cette cavité borgne peut présenter différentes profondeurs, pouvant s'étendre jusqu'à 90% au maximum de la hauteur de la couche métallique 13. La cavité peut laisser un minimum de matière au fond de la cavité 14, d'une hauteur supérieure ou égale à 10 µm. Autrement dit, la cavité 14 est séparée du substrat 10 par une épaisseur supérieure ou égale à 10 µm de matière de la première couche métallique 13. La profondeur de la cavité 14 peut être choisie en fonction de la géométrie finale du composant et selon les contraintes mécaniques qu'il va subir, une plus grande profondeur assurant une meilleure imbrication des deux couches superposées et donc une meilleure résistance mécanique finale.

En variante non représentée, une cavité pourrait être traversante (débouchante), cette étape supprimant le métal de la première couche métallique 13 sur toute sa hauteur en une certaine zone, laissant apparaître une partie de la couche conductrice 11 du substrat.
Dans le mode de réalisation illustré par la figure 4, la cavité 14 présente des flancs 17 sensiblement verticaux, et donc sensiblement perpendiculaires à la surface supérieure 15 de la couche métallique 13.

Selon l'invention la cavité 14 présente des flancs 17 inclinés, de sorte que la cavité 14 présente une section horizontale plus importante lorsque la profondeur augmente. En variante, les flancs 17 peuvent présenter toute forme non verticale (non totalement perpendiculaire au substrat), de sorte de la cavité 14 comprend une section plane horizontale plus importante à au moins une profondeur sous le niveau de la surface supérieure 15 de la couche métallique 13 que son ouverture 19 au niveau de la surface supérieure 15 de la couche métallique 13. Ces flancs ne sont ainsi pas nécessairement plans. Ils peuvent être courbés. Ils ne sont pas non plus nécessairement continus. Ils peuvent présenter des marches. Dans tous les cas, cette approche améliore encore l'ancrage relatif des deux couches, notamment l'ancrage ou la tenue en direction verticale.

En variante, plusieurs cavités, de dimensions, profondeur, et/ou géométrie différentes ou non peuvent être formées.
Selon le mode de réalisation illustré par la figure 5, les flancs 17 de la cavité 14 sont inclinés de manière continue de sorte que la section plane de la cavité augmente continument avec sa profondeur sous la surface supérieure 15 de la couche métallique 13. Notamment, la cavité illustrée présente une section selon un plan vertical en forme de queue d'aronde. Cette cavité peut être usinée avec une fraise d'angle ou une fraise pour queue d'aronde, ou par ablation laser avec une incidence oblique du faisceau laser 30.

Le procédé comprend ensuite une étape de dépôt d'une deuxième couche de résine, dans cet exemple à nouveau une couche de résine photosensible négative SU-8. En variante, une résine différente peut être utilisée. Cette deuxième couche est déposée de manière à recouvrir le premier niveau N1. Elle définit ainsi un deuxième niveau N2, s'étendant verticalement au-dessus du premier niveau N1. La hauteur du deuxième niveau N2 est avantageusement strictement supérieure à 0 et inférieure ou égale à 1,5 mm. Elle peut être égale ou différente de la hauteur du premier niveau, dépendant de la hauteur du second niveau du composant final à fabriquer. En remarque, la résine remplit aussi la cavité 14 du premier niveau N1. L'étape E4 d'obtention d'un deuxième moule 22, comme illustré par la figure 6, est finalisée par photolithographie de la deuxième couche de résine, par des étapes de photolithographie et de développement, analogues à celles des étapes précédemment décrites pour former le moule de résine du premier niveau.

Le procédé comprend ensuite une seconde étape E5 d'électrodéposition ou de dépôt galvanique, consistant à déposer une deuxième couche métallique 23 dans le moule 22. Cette couche emplit tout le volume de la cavité 14 puis s'étend au-dessus de la surface supérieure 15 de la première couche métallique 13. Elle présente de préférence une hauteur d'au moins 10 µm au-dessus de la première couche métallique 13, notamment au-dessus de la cavité 14. Elle peut remplir tout ou partie de la hauteur de ce second moule de résine 22 de deuxième niveau N2. La couche métallique 23 comprend ainsi une extension 27 qui occupe la cavité 14.

Cette étape peut être suivie de manière optionnelle d'une mise d'épaisseur, par polissage mécanique de la couche métallique et de la résine. Le résultat de cette étape est illustré par la figure 7.

En remarque, l'électrodéposition de la deuxième couche métallique est ici amorcée par le métal déposé du premier niveau, à la fois par sa surface supérieure 15 et par les surfaces intérieures de la cavité 14 borgne. En variante, elle pourrait être amorcée par la couche conductrice 11 recouvrant le substrat 10 au niveau de la cavité 14 si elle est débouchante.

La résine restante des niveaux N1 et N2 est ensuite enlevée (ou « strippée »), par exemple par voie humide ou voie sèche.

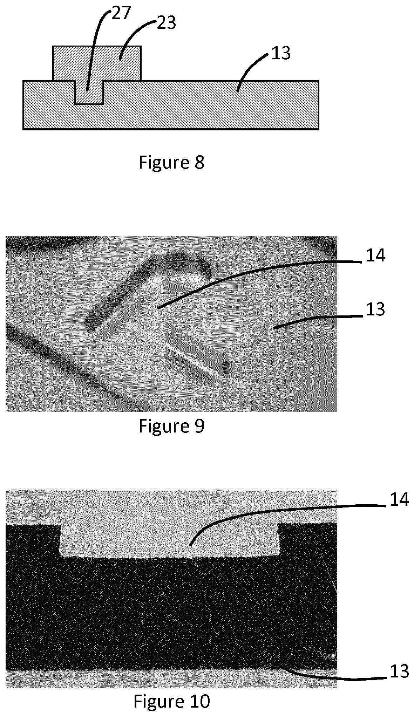

De même, le substrat 10 est retiré, par exemple par voie chimique, par exemple par dissolution chimique de la couche conductrice, pour finalement obtenir le composant illustré par la figure 8, qui se présente en deux niveaux, chaque niveau correspondant à une couche métallique 13, 23 distincte du procédé de fabrication. Ces deux couches, réalisées lors d'étapes d'électroformage distinctes, sont imbriquées, la seconde couche métallique 23 comprenant une extension inférieure 27 logée dans la cavité 14 de la première couche métallique 13.

En variante, le substrat 10 pourrait être détaché avant dissolution de la résine. Dans ce cas, la résine restante des niveaux N1 et N2 et les composants réalisés par électrodéposition seraient détachés du substrat avant élimination de la résine.

Optionnellement, des opérations de reprise ou d'usinage ou de modification de surface, comme le dépôt d'un revêtement, peuvent être effectués sur les composants électrodéposés, que ce soit avant ou après détachage du substrat et/ou avant ou après élimination de la résine.

Le procédé de fabrication a été illustré à l'aide d'un composant simple à deux niveaux pour faciliter la description du mode de réalisation. En variante, il est naturellement adapté à la fabrication d'un composant plus complexe, avec par exemple plus de deux niveaux, obtenus par la répétition des étapes de superposition de couches métalliques. Parmi ces couches, au moins deux couches superposées sont imbriquées, par une étape de formation d'au moins une cavité telle qu'explicitée ci-dessus. Ainsi, le procédé décrit précédemment peut être reproduit de manière similaire pour former deux couches métalliques successives qui ne sont pas obligatoirement les deux premières couches au-dessus du substrat. Il peut y avoir plusieurs couples de couches métalliques superposées imbriquées entre elles, voire toutes les couches superposées peuvent être imbriquées entre elles selon le même procédé que celui décrit précédemment, c'est-à-dire que toute couche métallique comprend alors une extension dans sa partie inférieure imbriquée dans une cavité de la couche métallique sur laquelle elle repose.

En variante, une première couche peut même être imbriquée avec les deux (ou plus) couches inférieures, par une extension traversant entièrement la seconde couche immédiatement inférieure, qui comprend à cet effet une cavité débouchante, puis venant s'imbriquer dans une cavité de la troisième couche située sous la seconde couche. Par ce biais, une couche peut être ancrée simultanément dans plusieurs couches inférieures.

Les différentes couches métalliques du composant peuvent se présenter dans un même métal, ou en variante dans des matériaux différents.

Le procédé présente finalement les avantages suivants :
- le temps de fabrication est optimal car il ne demande pas de formation d'un moule en résine complexe pour obtenir l'imbrication ou l'encastrement de couches métalliques superposées ;
- la formation de la cavité, dont la forme peut être optimisée, permet une imbrication ou un encastrement optimal des différentes couches. Par exemple, la cavité avec flancs élargissant la section de la cavité, notamment en queue d'aronde, permet une imbrication ou un encastrement très avantageux des deux couches superposées, qui induit une tenue en direction verticale améliorée et/ou une meilleure résistance au cisaillement ;
- Dans tous les cas, on fait croître une deuxième couche métallique à partir du fond d'une cavité d'une première couche métallique, ce qui la rend intimement liée et ancrée à la première couche métallique et assure la robustesse de l'ensemble. Le composant métallique obtenu possède plusieurs niveaux successifs réalisés par des couches métalliques distinctes, notamment électroformées, dont au moins certaines sont imbriquées et/ou encastrées, ce qui le rend très robuste, notamment vis-à-vis d'efforts de cisaillement.

Le procédé précédemment décrit de fabrication d'un composant métallique peut être utilisé pour la fabrication de composants horlogers tels que, à titre d'exemples illustratifs et non limitatifs, une ancre, un sautoir, une roue, un râteau, un ressort, un balancier, une came, un engrenage ou encore un pont. Il peut naturellement aussi être utilisé pour fabriquer tout élément métallique sous forme de microstructure.

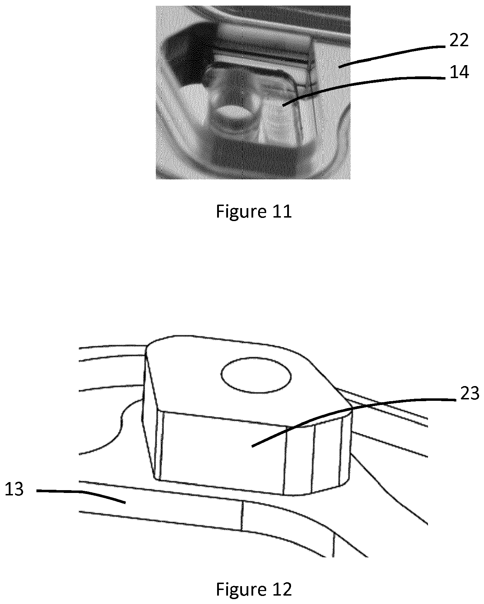

Les figures 9 à 12 illustrent à titre d'exemple la fabrication d'un sautoir. Les figures 9 et 10 illustrent le résultat obtenu après une étape intermédiaire de réalisation d'une cavité 14 dans une première couche métallique 13. La figure 10 permet notamment de visualiser la forme en queue d'aronde obtenue pour la cavité 14. La figure 11 montre le résultat intermédiaire après formation du moule 22 en résine de second niveau. On distingue la cavité 14 au fond du moule. Le composant est finalisé par croissance d'une seconde couche métallique 23, pour former le second niveau du sautoir, comme illustré sur la figure 12.

Selon une variante du mode de réalisation, le procédé peut comprendre une étape d'ajout d'un insert dans au moins une partie d'une cavité 14, suivie d'une étape de croissance d'une nouvelle couche métallique, qui permet non seulement d'imbriquer la nouvelle couche métallique dans la précédente mais aussi de solidariser l'insert au composant final, et notamment aux deux couches superposées, de l'enserrer. L'insert peut ainsi être simplement placé ou chassé dans la cavité. Cet insert peut être en matériau métallique ou conducteur, ou en matériau isolant comme le rubis, le silicium ou la céramique.

D'autre part, une variante du procédé de fabrication décrit précédemment est obtenue en procédant au retrait anticipé du substrat 10 du reste de la structure, et optionnellement de l'éventuelle couche conductrice 11.

En pratique, ce retrait peut être mis en œuvre dès que la première couche métallique est fabriquée, c'est-à-dire après la réalisation de l'étape E2 décrite précédemment, dont le résultat est illustré par la figure 3. Il en résulte une feuille solidaire formée de la première couche métallique 13 et de la résine 12, soit le premier niveau N1 de la structure. Cette feuille remplit finalement la fonction de substrat pour la poursuite du procédé.

Cette séparation anticipée de la feuille du substrat 10 présente les premiers avantages suivants :
- Elle permet toujours la poursuite du procédé de fabrication, comme par exemple la formation d'une cavité borgne (étape E3) dans la couche métallique 13 de la feuille, mais également la réalisation d'un ou plusieurs moules 22 supplémentaires en résine (étape E4), et le dépôt galvanique ou par électrodéposition pour former une nouvelle couche métallique 23 (étape E5), et la répétition de ces étapes pour former des couches superposées supplémentaires, et éventuellement l'insertion d'un objet (insert) ;
- Elle permet aussi toujours des opérations optionnelles de mise à niveau, usinage intermédiaire, ... ;
- La feuille est mince et facile à manipuler pour la mise en œuvre de ces opérations.

Cette variante de réalisation permet en outre la mise en œuvre d'étapes du procédé impossibles à mettre en œuvre sans le retrait du substrat. Notamment, elle permet de construire des éléments du composant métallique sous la feuille, plus exactement à partir de la surface inférieure 18 de la première couche métallique 13. Par exemple, une ou plusieurs autres couches métalliques peuvent être ajoutées par croissance à cette couche métallique, par dépôt galvanique ou électrodéposition, par exemple par un procédé LIGA tel que décrit précédemment. Si une couche conductrice 11 a été déposée préalablement au dépôt de la première couche métallique 13, il est possible soit de conserver cette couche conductrice pour les opérations subséquentes, soit de l'éliminer. La feuille sert ainsi de support initial à partir duquel il est possible d'ajouter des couches métalliques sur et sous la première couche métallique 13. Un avantage de l'ajout d'une couche sous cette feuille est de profiter de la planéité de la surface inférieure 18 préalablement construite sur le support 10. Ainsi, pour un composant métallique de trois niveaux à fabriquer, il est avantageux de disposer deux couches respectivement sur et sous la feuille pour profiter de la planéité bien maîtrisée des deux surfaces supérieure 15 et inférieure 18 de la feuille.

Naturellement, il est aussi possible de procéder à une étape de formation d'une cavité dans la surface inférieure 18 de la première couche métallique 13, pour obtenir une imbrication de la couche métallique formée sous cette surface, de manière similaire à la description exposée ci-dessus. En remarque, la première couche métallique 13 de la feuille peut ainsi comprendre des cavités 14 à la fois dans sa partie supérieure et dans sa partie inférieure.

En remarque, il est possible de déposer une couche conductrice sur l'une des surfaces de la couche métallique, voire sur les deux surfaces. En remarque, l'expression « croissance sous cette couche ou surface » signifie dans le contexte qui précède « sur ou à partir de la surface inférieure de la couche détachée du substrat », la croissance ayant lieu à partir de la surface inférieure 18.

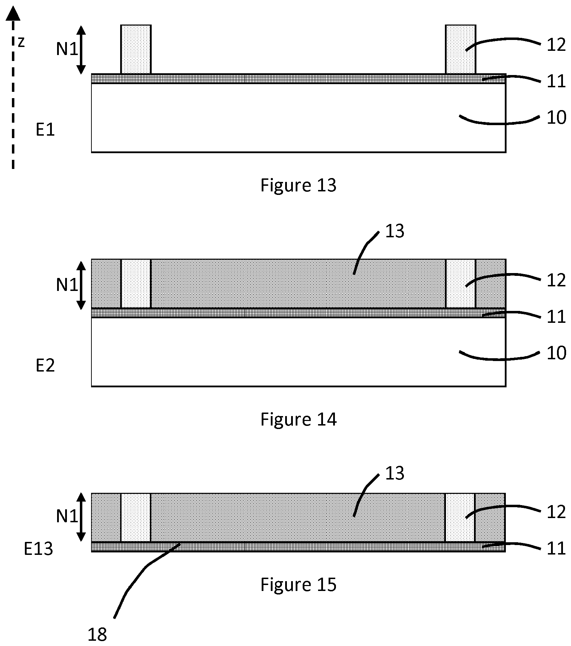

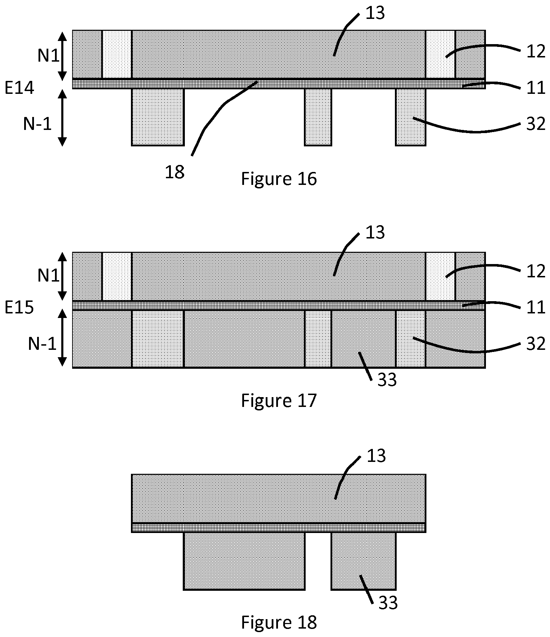

Ainsi, les figures 13 à 18 illustrent partiellement la mise en œuvre de la variante du procédé de fabrication décrite précédemment en procédant au retrait anticipé du substrat 10. Les figures 13 et 14 illustrent la fabrication d'une première couche métallique 13 sur un substrat 10 (étapes E1 et E2), comme cela a été décrit en référence avec les figures 2 et 3. A ce stade, le substrat 10 est détaché ou supprimé, dans une étape E13, pour atteindre la structure représentée sur la figure 15, dénommée feuille. La figure 16 illustre une étape E14 de réalisation d'un moule 32 en résine à partir de la surface inférieure de la feuille, de la même manière que dans les étapes E1 et E4 décrites en détail précédemment, avant une étape E15 de croissance d'une couche métallique 33 délimitée par ce moule 32, toujours selon le même procédé que celui détaillé précédemment, par exemple mis en œuvre dans les étapes E2 et E5. Ce procédé définit ainsi un deuxième niveau N-1, s'étendant verticalement au-dessous du premier niveau N1. Après retrait de la résine, dans une étape E16, un composant métallique à deux niveaux est obtenu, comme illustré par la figure 18.

Ensuite, d'autres couches peuvent être réalisées au-dessus de la couche métallique 13 supérieure de ce composant métallique à deux niveaux, par la mise en œuvre des étapes E3 à E5, et leur répétition éventuelle, comme décrit précédemment. Toutes les étapes décrites précédemment peuvent être mises en œuvre sur ce composant. En complément et/ou variante, un ou plusieurs autres couches métalliques peuvent être ajoutées à partir de la surface inférieure de ce composant métallique à deux niveaux, par croissance des couches à partir de cette surface, à partir d'étapes équivalentes aux étapes E3 à E5 décrites précédemment. En variante, la résine peut être retirée à un moment ultérieur du procédé.

Selon une autre variante de réalisation, le retrait anticipé du substrat pourrait se faire à toute autre étape ultérieure du procédé. Par exemple, ce retrait pourra être fait juste avant la formation de la dernière couche métallique du composant, et donc avant la dernière étape de dépôt galvanique ou électrodéposition, et éventuellement avant la dernière étape de formation d'un moule en résine. Au plus tard, ce retrait pourrait être fait avant les dernières opérations optionnelles de mise à niveau ou d'usinage de la surface supérieure obtenue lors de la dernière étape de dépôt galvanique ou électrodéposition. En variante, ce retrait pourrait être fait avant une dernière opération de mise à niveau de la surface supérieure obtenue lors de la dernière étape de dépôt galvanique ou électrodéposition. En variante, ce retrait pourrait être fait avant une dernière opération d'usinage de la surface supérieure obtenue lors de la dernière étape de dépôt galvanique ou électrodéposition.

L'invention porte aussi sur un composant horloger à plusieurs niveaux en tant que tel, obtenu par le procédé tel que décrit précédemment. Ainsi, un tel composant horloger comprend deux niveaux adjacents formés par deux couches métalliques 13, 23 distinctes au moins partiellement superposées, caractérisé en ce qu'une première couche métallique 13 présente au moins une cavité 14 et en ce que la seconde couche métallique 23 occupe le volume de ladite cavité 14 de la première couche métallique, et donc en ce que la deuxième couche comprend une extension 27 qui remplit cette cavité. Ces deux couches ont été fabriquées par dépôt galvanique ou électrodéposition, ce qui assure leur fixation au niveau de leur interface, à la fois entre leurs deux surfaces de contact respectives supérieure et inférieure, à la frontière entre les deux niveaux du composant, et sur les surfaces de contact au sein de la cavité 14 de la première couche métallique. La cavité peut être borgne, c'est-à-dire qu'elle ne traverse pas complètement le composant et qu'elle n'atteint pas le substrat, et donc que sa surface inférieure se situe dans la masse d'une couche déposée sur le substrat. Selon l'invention, cette cavité présente un flanc non perpendiculaire à la surface frontière entre les couches au niveau de la cavité, par exemple un flanc incliné, par exemple formant une section en queue d'aronde. En variante, la cavité comprenant un flanc non perpendiculaire à la surface supérieure de la première couche, par exemple un flanc incliné, par exemple formant une section en queue d'aronde, peut-être débouchante, c'est à dire occuper toute la hauteur de la première couche.

## Revendications

1. Procédé de fabrication d'un composant horloger, notamment à plusieurs niveaux, comprenant une étape de fabrication d'au moins une couche métallique (13) du composant horloger présentant une surface supérieure (15), **caractérisé en ce qu'**il comprend les étapes suivantes :
- E3 : Former au moins une cavité (14) dans la surface supérieure (15) de la couche métallique (13) du composant horloger, la cavité comprenant la réalisation d'au moins un flanc (17) non perpendiculaire à ladite surface supérieure (15) de la couche métallique (13), de sorte que ladite cavité (14) comprend une section plane plus importante à au moins une profondeur sous le niveau de la surface supérieure (15) que la section de son ouverture (19) au niveau de la surface supérieure (15) ;
- E5 : Former une autre couche métallique (23) au moins partiellement superposée à ladite surface supérieure (15) comprenant une cavité (14), par un dépôt galvanique d'un métal ou d'un alliage, remplissant ladite au moins une cavité (14).

2. Procédé de fabrication d'un composant horloger selon la revendication précédente, **caractérisé en ce que** l'étape consistant à former une autre couche métallique (23) du composant horloger comprend les étapes suivantes :
- E4 : Déposer une résine photosensible sur la surface supérieure (15) comprenant la au moins une cavité (14) ;
- E4 : Exposer la résine photosensible à travers un masque et développer la résine pour former un moule (22), libérant au moins une cavité (14) de la surface supérieure (15) ;
- E5 : Déposer un métal ou un alliage galvaniquement dans la au moins une cavité et en remplissant au moins une partie de la hauteur du moule (22).

3. Procédé de fabrication d'un composant horloger selon l'une des revendications précédentes, **caractérisé en ce que** l'autre couche métallique (23) est formée au-delà de la surface supérieure (15) de la couche métallique (13) et au-dessus de la cavité (14), sur une hauteur supérieure ou égale à 10µm.

4. Procédé de fabrication d'un composant horloger selon l'une des revendications précédentes, **caractérisé en ce que** l'étape (E3) de former au moins une cavité (14) comprend la formation d'au moins un trou borgne, de profondeur inférieure ou égale à 90% de la hauteur de la couche métallique (13).

5. Procédé de fabrication d'un composant horloger selon l'une des revendications précédentes, **caractérisé en ce que** l'étape (E3) de former au moins une cavité (14) comprend la réalisation de flancs (17) inclinés de sorte que la section plane de la cavité (14) augmente avec sa profondeur sous la surface supérieure (15) de la couche métallique (13), notamment afin de former une section en forme de queue d'aronde dans un plan perpendiculaire à la surface supérieure (15) dudit composant.

6. Procédé de fabrication d'un composant horloger selon l'une des revendications précédentes, **caractérisé en ce que** l'étape (E3) de former au moins une cavité (14) comprend une étape d'usinage mécanique, comme un fraisage et/ou un perçage, ou une ablation laser, ou un usinage chimique, ou un usinage par ultrasons, ou un usinage par électroérosion, ou un usinage localisé par décharge dans un milieu diélectrique.

7. Procédé de fabrication d'un composant horloger selon l'une des revendications précédentes, **caractérisé en ce qu'**il comprend les étapes suivantes :
- E1 : Déposer une résine photosensible sur la surface d'un substrat (10) ou d'une structure mono ou multicouches ;
- E1 : Exposer la résine photosensible à travers un masque et développer la résine pour former un moule (12) ;
- E2 : Déposer un métal ou un alliage galvaniquement dans le moule (12) pour former une nouvelle couche métallique (13) de surface supérieure (15);
- E3 : Former au moins une cavité (14) dans la surface supérieure (15) de la nouvelle couche métallique (13);
- E4 : Déposer une résine photosensible sur la surface supérieure (15) comprenant ladite au moins une cavité (14) de la nouvelle couche métallique;
- E4 : Exposer la résine photosensible à travers un masque et développer la résine pour former un nouveau moule (22), libérant au moins une cavité (14) de la surface supérieure (15) de la nouvelle couche métallique (13) ;
- E5 : Déposer un métal ou un alliage galvaniquement dans la au moins une cavité (14) et dans le nouveau moule (22) ;
- Éventuellement répéter les étapes précédentes.

8. Procédé selon la revendication précédente, **caractérisé en ce qu'**il comprend tout ou partie des étapes complémentaires suivantes :
- Usiner la surface d'une nouvelle couche métallique (13, 23) formée par dépôt galvanique, comprenant ou non au moins une cavité, pour augmenter la planéité de la nouvelle couche métallique ;
- Déposer une couche conductrice sur une nouvelle couche métallique formée par dépôt galvanique, notamment au sein d'une cavité de cette nouvelle couche métallique ;
- Dissoudre la résine formant un moule (12, 22) d'une ou plusieurs couches métallique(s).

9. Procédé de fabrication d'un composant horloger selon l'une des revendications précédentes, **caractérisé en ce qu'**il comprend les étapes suivantes:
- E1 : Déposer une résine photosensible sur la surface plane d'un substrat ;
- E1 : Exposer la résine photosensible à travers un masque et développer la résine pour former un premier moule (12) ;
- E2 : Déposer un métal ou un alliage galvaniquement dans le moule (12) pour former une première couche métallique (13) comprenant une surface supérieure (15) ;
- E4, E5 : Superposer éventuellement d'autres couches métalliques sur cette surface supérieure (15) de la première couche métallique (13), pour obtenir une structure d'une ou plusieurs couches métalliques ;
- E13 : Séparer la structure obtenue par les étapes précédentes du substrat (10) ; puis,
- E3 : Former au moins une cavité dans la surface sensiblement plane d'une couche métallique du composant horloger ; puis
- E4, E5 : Réaliser au moins une autre couche métallique du composant horloger, remplissant ladite au moins une cavité et étant superposée à ladite au moins une cavité.

10. Procédé de fabrication d'un composant horloger selon la revendication précédente, **caractérisé en ce qu'**il comprend une étape consistant à former au moins une cavité (14) dans la surface inférieure (18) de la première couche métallique (13) précédemment disposée du côté du substrat et **en ce que** l'étape consistant à réaliser au moins une autre couche métallique du composant horloger après séparation du substrat comprend la réalisation d'une couche métallique sur la surface inférieure de la première couche précédemment disposée du côté du substrat par dépôt galvanique, remplissant au moins une cavité (14) de cette surface inférieure (18) de la première couche métallique.

11. Composant horloger, notamment à plusieurs niveaux, comprenant deux niveaux adjacents formés par deux couches métalliques (13, 23) distinctes au moins partiellement superposés, la seconde couche métallique (23) recouvrant au moins partiellement la surface supérieure (15) de la première couche métallique (13), **caractérisé en ce que** la première couche métallique (13) présente au moins une cavité (14) présentant un flanc (17) non perpendiculaire à la surface supérieure (15) de la première couche métallique (13) aux abords de la cavité, notamment un flanc incliné de sorte que la section de la cavité augmente en s'éloignant de la surface supérieure (15) de la première couche métallique (13) ou notamment une section en forme de queue d'aronde dans un plan perpendiculaire à la surface supérieure (15) dudit composant, et **en ce que** la seconde couche métallique (23) occupe le volume de ladite cavité (14) de la première couche métallique (13), de sorte que les deux couches métalliques (13, 23) sont imbriquées et fixées l'une à l'autre au niveau de leur interface.

12. Composant horloger selon la revendication 11 **caractérisé en ce qu'**il est l'un des éléments du groupe comportant un sautoir, une ancre, une roue, une came, un râteau.

13. Mouvement horloger ou pièce d'horlogerie, **caractérisé en ce qu'**il comprend un composant horloger selon l'une des revendications 11 à 12.

## Patentansprüche

1. Herstellungsverfahren für ein Uhrenbauteil, insbesondere mit mehreren Ebenen, umfassend einen Schritt zur Herstellung wenigstens einer Metallschicht (13) des Uhrenbauteils, welches eine Oberfläche (15) aufweist, **dadurch gekennzeichnet, dass** es die folgenden Schritte umfasst:
- E3: Bilden wenigstens einer Vertiefung (14) in der Oberfläche (15) der Metallschicht (13) des Uhrenbauteils, wobei die Vertiefung wenigstens die Ausbildung einer Seitenwand (17) umfasst, die nicht senkrecht zur Oberfläche (15) der Metallschicht (13) ausgerichtet ist, derart, dass die genannte Vertiefung (14) einen ebenen Abschnitt in wenigstens einer Tiefe unterhalb der Ebene der Oberfläche (15) umfasst, der größer ist als der Ausschnitt ihrer Öffnung (19) auf der Ebene der Oberfläche (15);
- E5: Bilden einer weiteren Metallschicht (23), die die genannte Oberfläche (15) wenigstens teilweise überlagert, umfassend eine Vertiefung (14), durch galvanisches Abscheiden eines Metalls oder einer Legierung, wobei die genannte wenigstens eine Vertiefung (14) gefüllt wird.

2. Herstellungsverfahren für ein Uhrenbauteil gemäß dem vorangehenden Anspruch, **dadurch gekennzeichnet, dass** der Schritt, eine weitere Metallschicht (23) des Uhrenbauteils zu bilden, die folgenden Schritte umfasst:
- E4: Aufbringen eines lichtempfindlichen Harzes auf die Oberfläche (15) umfassend die wenigstens eine Vertiefung (14);
- E4: Belichten des lichtempfindlichen Harzes durch eine Maske hindurch und Entwickeln des Harzes zur Bildung einer Form (22), Freilegen der wenigstens einen Vertiefung (14) der Oberfläche (15);
- E5: Galvanisches Abscheiden eines Metalls oder einer Legierung in die wenigstens eine Vertiefung und Füllen wenigstens eines Teils der Höhe der Form (22).

3. Herstellungsverfahren für ein Uhrenbauteil gemäß einem der vorangehenden Ansprüche, **dadurch gekennzeichnet, dass** die weitere Metallschicht (23) über der Oberfläche (15) der Metallschicht (13) gebildet wird und oberhalb der Vertiefung (14), auf einer Höhe über oder gleich 10 µm.

4. Herstellungsverfahren für ein Uhrenbauteil gemäß einem der vorangehenden Ansprüche, **dadurch gekennzeichnet, dass** der Schritt (E3) zur Bildung wenigstens einer Vertiefung (14) die Bildung wenigstens eines Sackloches umfasst, mit einer Tiefe kleiner oder gleich 90% der Höhe der Metallschicht (13).

5. Herstellungsverfahren für ein Uhrenbauteil gemäß einem der vorangehenden Ansprüche, **dadurch gekennzeichnet, dass** der Schritt (E3) zur Bildung wenigstens einer Vertiefung (14) die Ausbildung von Seitenwänden (17) umfasst, die so geneigt sind, dass der ebene Abschnitt der Vertiefung (14) mit zunehmender Tiefe unter der Oberfläche (15) der Metallschicht (13) größer wird, insbesondere derart, dass ein schwalbenschwanzförmiger Querschnitt gebildet wird in einer Ebene senkrecht zur Oberfläche (15) des genannten Bauteils.

6. Herstellungsverfahren für ein Uhrenbauteil gemäß einem der vorangehenden Ansprüche, **dadurch gekennzeichnet, dass** der Schritt (E3) zur Bildung wenigstens einer Vertiefung (14) einen mechanischen Bearbeitungsschritt umfasst, wie Fräsen und/oder Bohren, oder Laserablation, oder eine chemische Behandlung oder eine Ultraschallbehandlung, oder eine elektroerosive Bearbeitung oder eine Bearbeitung durch lokale elektrische Entladung in einem dielektrischen Medium.

7. Herstellungsverfahren für ein Uhrenbauteil gemäß einem der vorangehenden Ansprüche, **dadurch gekennzeichnet, dass** es die folgenden Schritte umfasst:
- E1: Aufbringen eines lichtempfindlichen Harzes auf die Oberfläche eines Substrats (10) oder einer ein- oder mehrschichtigen Struktur;
- E1: Belichten des lichtempfindlichen Harzes durch eine Maske hindurch und Entwickeln des Harzes zur Bildung einer Form (12);
- E2: Galvanisches Abscheiden eines Metalls oder einer Legierung in die Form (12) zur Bildung einer neuen Metallschicht (13) mit einer Oberfläche (15);
- E3: Bilden wenigstens einer Vertiefung (14) in der Oberfläche (15) der neuen Metallschicht (13);
- E4: Aufbringen eines lichtempfindlichen Harzes auf die Oberfläche (15) umfassend die genannte wenigstens eine Vertiefung (14) der neuen Metallschicht (13);
- E4: Belichten des lichtempfindlichen Harzes durch eine Maske und Entwickeln des Harzes zur Bildung einer neuen Form (22), Freilegen der wenigstens einen Vertiefung (14) der Oberfläche (15) der neuen Metallschicht (13);
- E5: Galvanisches Abscheiden eines Metalls oder einer Legierung in die wenigstens eine Vertiefung (14) und in die neue Form (22);
- eventuelles Wiederholen der vorangehenden Schritte.

8. Herstellungsverfahren für ein Uhrenbauteil gemäß dem vorangehenden Anspruch, **dadurch gekennzeichnet, dass** es alle oder einen Teil der folgenden Schritte umfasst:
- Bearbeiten der Oberfläche einer neuen Metallschicht (13, 23) gebildet durch galvanisches Abscheiden, mit oder ohne wenigstens einer Vertiefung, um die Ebenheit der neuen Metallschicht zu erhöhen;
- Aufbringen einer leitenden Schicht auf eine neue, durch galvanisches Abscheiden gebildete Metallschicht, insbesondere in eine Vertiefung dieser neuen Metallschicht hinein;
- Auflösen des eine Form (12, 22) bildenden Harzes einer oder mehrere Metallschichten.

9. Herstellungsverfahren für ein Uhrenbauteil gemäß einem der vorangehenden Ansprüche, **dadurch gekennzeichnet, dass** es die folgenden Schritte umfasst:
- E1: Aufbringen eines lichtempfindlichen Harzes auf die ebene Oberfläche eines Substrats;
- E1: Belichten des lichtempfindlichen Harzes durch eine Maske hindurch und Entwickeln des Harzes zur Bildung einer ersten Form (12);
- E2: Galvanisches Abscheiden eines Metalls oder einer Legierung in die Form (12) zur Bildung einer ersten Metallschicht (13) umfassend eine Oberfläche (15);
- E4, E5: eventuelles Legen weiterer Metallschichten über diese Oberfläche (15) der ersten Metallschicht (13), um eines Struktur aus einer oder mehrerer Metallschichten zu erhalten;
- E13: Trennen der erhaltenen Struktur durch die vorangehenden Schritte des Substrats (10); dann,
- E3: Bilden wenigstens einer Vertiefung in der im Wesentlichen ebenen Oberfläche einer Metallschicht des Uhrenbauteils; dann
- E4, E5: Bilden wenigstens einer weiteren Metallschicht des Uhrenbauteils, Füllen der wenigstens einen Vertiefung und Überlagern der wenigstens einen Vertiefung.

10. Herstellungsverfahren für ein Uhrenbauteil gemäß dem vorangehenden Anspruch, **dadurch gekennzeichnet, dass** es einen Schritt zur Bildung wenigstens einer Vertiefung (14) in die untere Oberfläche (18) der ersten Metallschicht (13) umfasst, die vorher auf die Seite des Substrats aufgebracht wurde und, dass der Schritt umfassend die Bildung wenigstens einer weiteren Metallschicht des Uhrenbauteils nach der Trennung vom Substrat die Bildung einer Metallschicht auf der unteren Oberfläche der ersten Schicht umfasst, die vorher auf die Seite des Substrats durch galvanisches Abscheiden aufgebracht wurde, wobei wenigstens eine Vertiefung (14) dieser unteren Oberfläche (18) der ersten Metallschicht gefüllt wird.

11. Uhrenbauteil, insbesondere mit mehreren Ebenen, umfassend zwei benachbarte Ebenen gebildet durch zwei verschiedene Metallschichten (13, 23), die sich wenigstens teilweise überlagern, wobei die zweite Metallschicht (23) wenigstens teilweise die Oberfläche (15) der ersten Metallschicht (13) überdeckt, **dadurch gekennzeichnet, dass** die erste Metallschicht (13) wenigstens eine Vertiefung (14) aufweist mit einer Seitenwand (17), die nicht senkrecht zur Oberfläche (15) der ersten Metallschicht (13) ausgerichtet ist am Rande der Vertiefung, insbesondere einer derart geneigte Seitenwand, dass der Querschnitt der Vertiefung sich mit zunehmendem Abstand von der Oberfläche (15) der ersten Metallschicht (13) vergrößert, oder insbesondere ein schwalbenschwanzförmiger Querschnitt in einer Ebene senkrecht zur Oberfläche (15) des genannten Bauteils entsteht, und dass die zweite Metallschicht (23) das Volumen der genannten Vertiefung (14) der ersten Metallschicht (13) einnimmt, derart, dass die zwei Metallschichten (13, 23) ineinandergreifen und untereinander an ihren Grenzflächen befestigt sind.

12. Uhrenbauteil gemäß Anspruch 11, **dadurch gekennzeichnet, dass** es ein Bauteil aus der Gruppe ist, umfassend ein Sautoir, einen Anker, ein Zahnrad, eine Kurvenscheibe, einen Rechen.

13. Uhrwerk oder Uhr, **dadurch gekennzeichnet, dass** es/sie ein Uhrenbauteil gemäß den Ansprüchen 11 bis 12 umfasst.

## Claims

1. A process for manufacturing a timepiece component, in particular a multi-level timepiece component, comprising a step of manufacturing at least one metal layer (13) of the timepiece component having an upper surface (15), **characterized in that** it comprises the following steps:
- E3: forming at least one cavity (14) in the upper surface (15) of the metal layer (13) of the timepiece component, the cavity (14) comprising the production of at least one side wall (17) not perpendicular to the upper surface (15) of the metal layer (13), so that said cavity (14) comprises a flat cross section greater, at at least one depth below the level of the upper surface (15), than the cross section of its opening (19) level with the upper surface (15) ;
- E5: forming another metal layer (23) at least partially superposed on said upper surface (15) comprising a cavity (14), by a galvanic deposition of a metal or of an alloy, filling said at least one cavity (14).

2. The process for manufacturing a timepiece component as claimed in the preceding claim, **characterized in that** the step consisting in forming another metal layer (23) of the timepiece component comprises the following steps:
- E4: depositing a photoresist on the upper surface (15) comprising the at least one cavity (14);
- E4: exposing the photoresist through a mask and developing the resist in order to form a mold (22), freeing up at least one cavity (14) of the upper surface (15);
- E5: depositing a metal or an alloy galvanically in the at least one cavity and filling at least one portion of the height of the mold (22).

3. The process for manufacturing a timepiece component as claimed in either of the preceding claims, **characterized in that** the other metal layer (23) is formed beyond the upper surface (15) of the metal layer (13) and above the cavity (14), to a height greater than or equal to 10 µm.

4. The process for manufacturing a timepiece component as claimed in one of the preceding claims, **characterized in that** the step (E3) of forming at least one cavity (14) comprises the formation of at least one blind hole, having a depth of less than or equal to 90% of the height of the metal layer (13).

5. The process for manufacturing a timepiece component as claimed in one of the preceding claims, **characterized in that** the step (E3) of forming at least one cavity (14) comprises the production of side walls (17) that are inclined so that the flat cross section of the cavity (14) increases with its depth below the upper surface (15) of the metal layer (13), in particular in order to form a cross section of dovetail shape in a plane perpendicular to the upper surface (15) of said component.

6. The process for manufacturing a timepiece component as claimed in one of the preceding claims, **characterized in that** the step (E3) of forming at least one cavity (14) comprises a step of mechanical machining, such as a milling and/or a drilling, or a laser ablation, or a chemical machining, or an ultrasound machining, or an electrical discharge machining, or a localized machining by discharge in a dielectric medium.

7. The process for manufacturing a timepiece component as claimed in one of the preceding claims, **characterized in that** it comprises the following steps:
- E1: depositing a photoresist on the surface of a substrate (10) or of a single-layer or multilayer structure;
- E1: exposing the photoresist through a mask and developing the resist in order to form a mold (12);
- E2: depositing a metal or an alloy galvanically in the mold (12) in order to form a new metal layer (13) having an upper surface (15);
- E3: forming at least one cavity (14) in the upper surface (15) of the new metal layer (13);
- E4: depositing a photoresist on the upper surface (15) comprising said at least one cavity (14) of the new metal layer;
- E4: exposing the photoresist through a mask and developing the resist in order to form a new mold (22), freeing up at least one cavity (14) of the upper surface (15) of the new metal layer (13);
- E5: depositing a metal or an alloy galvanically in the at least one cavity (14) and in the new mold (22);
- optionally repeating the preceding steps.

8. The process as claimed in the preceding claim, **characterized in that** it comprises all or some of the following additional steps:
- machining the surface of a new metal layer (13, 23) formed by galvanic deposition, comprising or not at least one cavity, in order to increase the flatness of the new metal layer;
- depositing a conductive layer on a new metal layer formed by galvanic deposition, in particular within a cavity of this new metal layer;
- dissolving the resist forming a mold (12, 22) having one or more metal layer(s).

9. The process for manufacturing a timepiece component as claimed in one of the preceding claims, **characterized in that** it comprises the following steps:
- E1: depositing a photoresist on the flat surface of a substrate;
- E1: exposing the photoresist through a mask and developing the resist in order to form a first mold (12);
- E2: depositing a metal or an alloy galvanically in the mold (12) in order to form a first metal layer (13) having an upper surface (15);
- E4, E5: optionally superposing other metal layers on this upper surface (15) of the first metal layer (13) in order to obtain a structure having one or more metal layers;
- E13: separating the structure obtained by the preceding steps from the substrate (10); then,
- E3: forming at least one cavity in the substantially flat surface of a metal layer of the timepiece component; then
- E4, E5: producing at least one other metal layer of the timepiece component, filling said at least one cavity and being superposed on said at least one cavity.

10. The process for manufacturing a timepiece component as claimed in the preceding claim, **characterized in that** it comprises a step that consists in forming at least one cavity (14) in the lower surface (18) of the first metal layer (13) previously positioned on the side of the substrate and **in that** the step consisting in producing at least one other metal layer of the timepiece component after separation of the substrate comprises the production of a metal layer on the lower surface of the first layer previously positioned on the side of the substrate by galvanic deposition, filling at least one cavity (14) of this lower surface (18) of the first metal layer.

11. A timepiece component, in particular a multi-level timepiece component, comprising two adjacent levels formed by two separate metal layers (13, 23) that are at least partially superposed, the second metal layer (23) at least partially covering the upper surface (15) of the first metal layer (13), **characterized in that** the first metal layer (13) has at least one cavity (14) having a side wall (17) that is not perpendicular to the upper surface (15) of the first metal layer (13) in the area around the cavity, in particular a side wall inclined so that the cross section of the cavity increases on moving away from the upper surface (15) of the first metal layer (13) or in particular a cross section of dovetail shape in a plane perpendicular to the upper surface (15) of said component, and **in that** the second metal layer (23) occupies the volume of said cavity (14) of the first metal layer (13), so that the two metal layers (13, 23) are interlocked and fastened to one another at their interface.

12. The timepiece component as claimed in claim 11, **characterized in that** it is one of the elements of the group comprising a jumper, a pallet, a wheel, a cam, a rack.

13. A timepiece movement or timepiece part, **characterized in that** it comprises a timepiece component as claimed in one of claims 11 to 12.
